# EUROPÄISCHE PATENTSCHRIFT

(11) **EP 1 332 499 B1**
(45) Veröffentlichungstag und Bekanntmachung des Hinweises auf die Patenterteilung: **26.07.2006**
(21) Anmeldenummer: 01993930.5
(22) Anmeldetag: 31.10.2001
(51) Int. Cl.: G11C 11/00

(54) **MAGNETORESISTIVER SPEICHER (MRAM)**
MAGNETORESISTIVE MEMORY (MRAM)
MEMOIRE MAGNETORESISTIVE (MRAM)

(30) Priorität: 10.11.2000 DE 10055936
(43) Veröffentlichungstag der Anmeldung: 06.08.2003
(73) Patentinhaber: Infineon Technologies AG, 81669 München (DE)
(72) Erfinder: FREITAG, Martin, 81543 München (DE); HOENIGSCHMID, Heinz, Essex Junction, VT 05452 (US); GOGL, Dietmar, Essex Junction, VT 05452 (US); LAMMERS, Stefan, South Burlington, VT 05403 (US)
(74) Vertreter: Beck, Josef
(86) Internationale Anmeldenummer: PCT/EP2001/012622
(87) Internationale Veröffentlichungsnummer: WO 2002/039454

(56) Entgegenhaltungen:
- DE-A- 10 043 947

## Beschreibung

Die Erfindung betrifft einen magnetoresistiven Speicher (MRAM) mit einer Vielzahl von Magnet-Speicherzellen, die an den Kreuzungspunkten eines aus einer Matrix von Spalten- und Zeilenzuleitungen aufgebauten Zellenfeldes angeordnet und an diese zum Leiten von Lese- und Schreibströmen vorgesehenen Zuleitungen angeschlossen sind, wobei sich bei einer Schreiboperation die durch die Schreibströme in den jeweiligen Zuleitungen erzeugten Magnetfelder in einem wahlfreien Kreuzungspunkt addieren und dadurch eine Ummagnetisierung der dortigen Speicherzelle ermöglichen.

Ein derartiger nichtflüchtiger magnetischer Speicher mit wahlfreiem Zugriff (MRAM) ist beispielsweise aus der DE 198 07 361 A1 bekannt.

Derzeit werden eine Vielzahl digitaler Speicher für Lese- und Schreiboperationen entwickelt, die als Speicherchips hoher Packungsdichte auf Magnetbasis (MRAM) bereits in wenigen Jahren die herkömmlichen Silizium-Chips (DRAM) wenigstens teilweise ersetzen könnten. Das MRAM-Konzept sieht vor, jeweils ein Bit von Information, d.h. den logischen Null ("0")- oder Eins ("1")-Zustand, in einer Speicherzelle zu speichern, die im Prinzip aus zwei magnetisierten Schichten, die zueinander parallel oder antiparallel magnetisiert sein können, besteht. Das Zellenfeld dieser Vielzahl von Speicherzellen wird aus einer Matrix von Spalten- und Zeilenzuleitungen aufgebaut. Diese Zuleitungen bestehen aus leitenden Materialien und an den Kreuzungspunkten der Zuleitungen befindet sich die eigentliche Speicherzelle. Um eine Änderung der Magnetisierung einer einzelnen Speicherzelle zu erreichen, ist es erforderlich, ein Magnetfeld, dessen Stärke einen bestimmten Schwellwert überschreitet, selektiv, also möglichst nur in unmittelbarer Nähe eines frei adressierbaren Kreuzungspunktes zu erzeugen. Das erforderliche Magnetfeld wird gemäß dem üblichen Selektionsmodus erst durch die Vektoraddition der in den zu einem bestimmten Kreuzungspunkt gehörenden, durch Spalten-und Zeilenzuleitung erzeugten beiden Magnetfelder erreicht.

Während die geschilderten Prinzipien der Schreiboperationen bei MRAMs schon seit längerem bekannt sind, lag in jüngerer Zeit der Entwicklungsschwerpunkt auf der Seite fortschrittlicher Leseoperationen. Die heutigen einzelnen Speicherzellen umfassen üblicherweise mindestens zwei magnetische Schichten, die durch eine Zwischenschicht getrennt sind. Die einzelnen Speicherzellen sind weiterhin durch eine Matrix von Zuleitungen angeschlossen. Diese Zuleitungen dienen nicht nur, wie oben beschrieben, dem Erzeugen von Magnetfeldern für Schreiboperationen, sondern sie leiten auch die Leseströme zum Auslesen der in den einzelnen Speicherzellen vorhandenen binären Informationen. Der magnetische Speicherzustand einer Speicherzelle wird nicht mehr durch externe Magnetsensoren, sondern durch Messung einer Eigenschaft, nämlich des Widerstandes, an der und durch die Speicherzelle selbst ermittelt.

Es kommen heute bereits mehrere verschiedene Magnetowiderstandseffekte in Frage, denen jeweils unterschiedliche physikalische Wirkprinzipien zugrunde liegen. In der Praxis geht es darum, bei Änderung der Magnetisierungsausrichtung von parallel nach antiparallel und umgekehrt große Widerstandsänderungen im Bereich von einigen Prozent zu realisieren, beispielsweise mittels des Riesenmagnetowiderstandseffekts (giant magneto resistance effect) (GMR) oder des Tunnelmagnetowiderstandseffekts (TMR, auch andere Abkürzungen sind gebräuchlich).

Der generelle Vorteil dieser MRAMs gegenüber herkömmlichen Halbleiterspeichern besteht in der persistenten Speicherung der Information, somit ist nach dem Ausschalten und Wiedereinschalten des Gerätes, in welchem die Speicherzellen verwendet werden, die gespeicherte Information sofort verfügbar.

Entfallen könnten auch die energieaufwendigen Auffrisch-Zyklen in Silizium-Chips. Dieser "Refresh" macht beispielsweise in Notebooks den Einsatz großer und schwerer Akkus erforderlich.

Problematisch bei derartigen MRAMs ist es, dass magnetische Streufelder von außerhalb des Speichers oder von Nachbarzellen Fehler im Speicherinhalt verursachen können, wenn sie eine ausreichende Größe haben. Da sich Magnetfelder nur schwer lokalisieren lassen, besteht besonders bei hohen Packungsdichten und somit eng aneinander liegenden Zuleitungen bzw. Speicherzellen die Gefahr, dass der magnetische Zustand und somit der Speicherinhalt benachbarter Zellen verändert wird.

In der eingangs genannten DE 198 07 361 A1 wird deshalb eine Abschirmungsschicht aus einem Werkstoff mit hoher Permeabilität vorgeschlagen, der externe magnetische Streufelder von der beschichteten Speicherzelle abschirmt und außerdem die durch die Schreibströme an der jeweiligen Speicherzelle erzeugten Magnetfelder auf diese Speicherzelle konzentriert, so dass eine kleinere Stromstärke zur Erzeugung eines zum Schreiben ausreichenden Gesamtmagnetfeldes benötigt wird.

Aus DE 100 43 947 ist ein magnetoresistiver Speicher bekannt, der zur Beeinflussung des erzeugbaren Magnetfeldes der Stromleiter im Querschnitt gesehen wenigstens eine Ausnehmung oder Eintiefung oder einen Bereich niedrigerer Leitfähigkeit an der der Speicherzelle zugewandten Seite aufweist.

Aus IEEE Transactions on magnetics, Vol. 33, no. 6, November 1997, pages 4498-4512, XP000831059. Zhi G. Wang EL AL: "Feasibility of Ultra-Dense Spin-Tunneling Radom Access Memory" ist ein Spin-Tunnel-Speicherbaustein bekannt, bei dem zur Optimierung des Magnetfeldes Abschirmvorrichtungen vorgesehen sind. Die Abschirmvorrichtungen bewirken eine gute Lokalisierung des Magnetfeldes am Speicherzellenort, sind aber aufwändig herzustellen.

Ziel der vorliegenden Erfindung ist es, einen magnetoresistiven Speicher (MRAM) der eingangs genannten Art so zu gestalten, dass sich ohne aufwendige Eingriffe in den Herstellungsablauf eine kontrollierte, insbesondere stärkere Lokalisierung des Magnetfeldes an der jeweiligen Speicherzelle, die somit mit höherer Selektivität adressierbar ist, ergibt. Außerdem sollen die Magnetfelder möglichst mit relativ geringer Stromstärke erzeugbar sein.

Die Erfindung ist durch Anspruch 1 definiert.

Erfindungsgemäß wird dieses Ziel bei einem magnetoresistiven Speicher (MRAM) der eingangs genannten Art dadurch erreicht, dass die Form der Zuleitungen durch Abweichen von einem quadratischen Querschnitt derselben derart optimiert ist

so dass die zuleitungen einen extrem flachen Querschnitt in Form eines seitlich angeschrägten Rechtecks aufweisen. Dadurch nimmt die in der Zellenfeldebene liegende Magnetfeldkomponente Bₓ mit zunehmender Entfernung vom Kreuzungspunkt ausreichend rasch ab, wodurch gleichzeitig eine höhere Selektivität und niedrigere Schaltströme resultieren. Letzteres ermöglicht kleinere Ansteuerschaltungen, somit auch eine geringere Chipfläche, weniger Elektromigration und weniger Leistungsaufnahme.

Nachdem bisher davon ausgegangen wurde, Zuleitungen mit annähernd quadratischem Querschnitt für den Aufbau eines MRAM zu verwenden, liegt der Erfindung nunmehr die Idee zugrunde, durch Optimierung der Form der Zuleitungen von vorneherein stärker als bisher lokalisierte Magnetfelder zu erzeugen, wobei sich gleichzeitig auch Möglichkeiten zur Optimierung der erforderlichen Stromstärke relativ zur geforderten Schwellwertstärke und Selektivität des Magnetfeldes ergeben.

Erfindungsgemäß können die neuen Speicherstrukturen z. B. mit Dünnschichttechnik und optischer Lithographie auf die üblichen Wafer integriert werden, wobei beispielsweise eine an sich bekannte CMOS-Schaltung auf dem MRAM-Chip die Lese-und Schreiboperationen steuert. Die Zuleitungen der Speicherzellen werden demgemäss durch spezielle Leiterbahnen aus Cu realisiert, die beispielsweise zwischen der vorletzten und letzten Verdrahtungsebene angeordnet sind. Von der Kompatibilität zum restlichen Leiterbahnsystem her und in Hinsicht auf Eigenschaften wie einfache Herstellbarkeit oder hohe Stromtragfähigkeit bieten sich eigentlich (annähernd) quadratische Leiterbahnquerschnitte an, wovon aber erfindungsgemäß in Richtung eines ausreichend stark abgeflachten Rechteck-Querschnitts abgewichen wird.

Eine besonders vorteilhafte Ausgestaltung des erfindungsgemäßen MRAMs besteht darin, Zuleitungen mit extrem flachen Querschnitt zu verwenden, wodurch gleichzeitig eine höhere Selektivität und niedrigere Schaltströme resultieren. Letzteres ermöglicht kleinere Ansteuerschaltungen, somit auch eine geringere Chipfläche, weniger Elektromigration und weniger Leistungsaufnahme.

Die Erfindung wird nachfolgend an Ausführungsbeispielen anhand der Zeichnungen näher erläutert. Es zeigt
Figur 1 eine schräge Draufsicht auf einen vereinfacht dargestellten Teil einer MRAM-Matrix in Übereinstimmung mit der vorliegenden Erfindung,
Figur 2 die Berechnungsgrundlagen für die Magnetfeldkomponenten mit Angabe eines Koordinatensystems,
Figur 3 den Verlauf der Magnetfeldstärke in Abhängigkeit der Entfernung x von der Mitte der Zuleitung für einen MRAM gemäß dem Stand der Technik sowie einen idealisierten Verlauf,
Figur 4 den Verlauf der Magnetfeldstärke in Abhängigkeit von der Entfernung x von der Mitte der Zuleitung für einen MRAM gemäß dem Stand der Technik,
Figur 5 in gleicher Darstellung wie in Figur 4 den Verlauf der Magnetfeldstärke für zwei Ausführungsformen eines MRAMs gemäß der Erfindung.

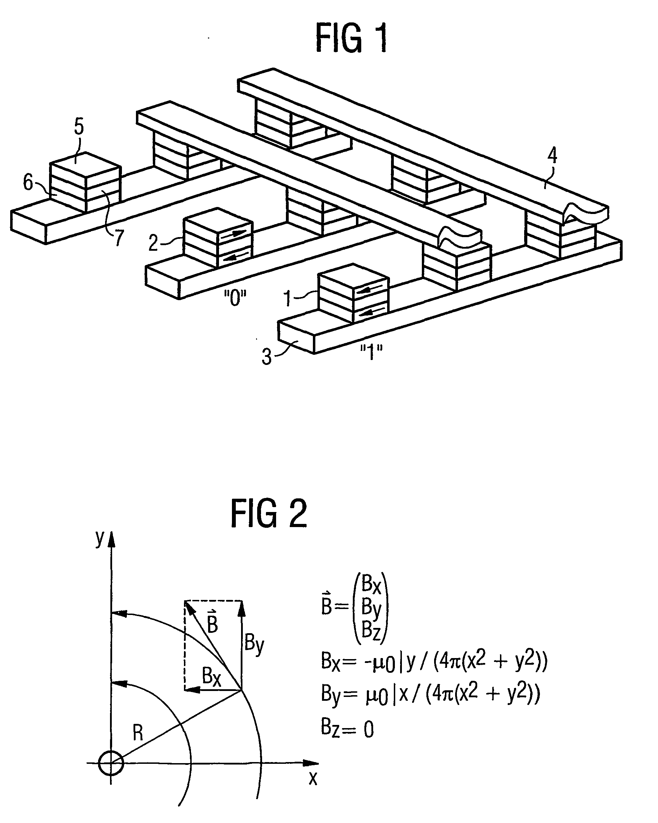

Figur 1 zeigt eine Anordnung aus 3x3 Speicherzellen 1 und 2, die mittels dreier Zeilenzuleitungen 3, auch Wordline genannt, und mittels zugehöriger Spaltenzuleitungen 4 (zur Vereinfachung sind nur zwei Zuleitungen dargestellt), auch Bitline genannt, angeschlossen sind. Die einzelnen Speicherzellen 1 und 2 können beispielsweise jeweils aus einer oberen weichmagnetischen Schicht 5, einer unteren hartmagnetischen Schicht 6 und einem dazwischen liegenden Tunneloxid 7, z. B. Al₂O₃, aufgebaut sein. Die Pfeile in den beiden unteren Speicherzellen der vordersten Spalte deuten mit ihrer parallelen oder antiparallelen Magnetisierung die logischen Zustände "1" und "0" dieser beiden Speicherzellen an.

Der erfindungsgemäßen Zuleitungsformoptimierung liegt die Berechnung des zugehörigen Magnetfeldes in Abhängigkeit von der Querschnittsform zugrunde. Zunächst wird das Magnetfeld eines stromdurchflossenen (idealisiert dünnen und unendlich langen) Leiters berechnet, das relativ einfach zu bestimmen ist. Für den Betrag des Magnetfeldes B im Abstand R vom Mittelpunkt der Zuleitung gilt: B=cI/R, wobei I der Strom und c eine Konstante ist. Die Richtung des Magnetfeldvektors kann über die so genannte "Rechte Hand"-Regel ermittelt werden.

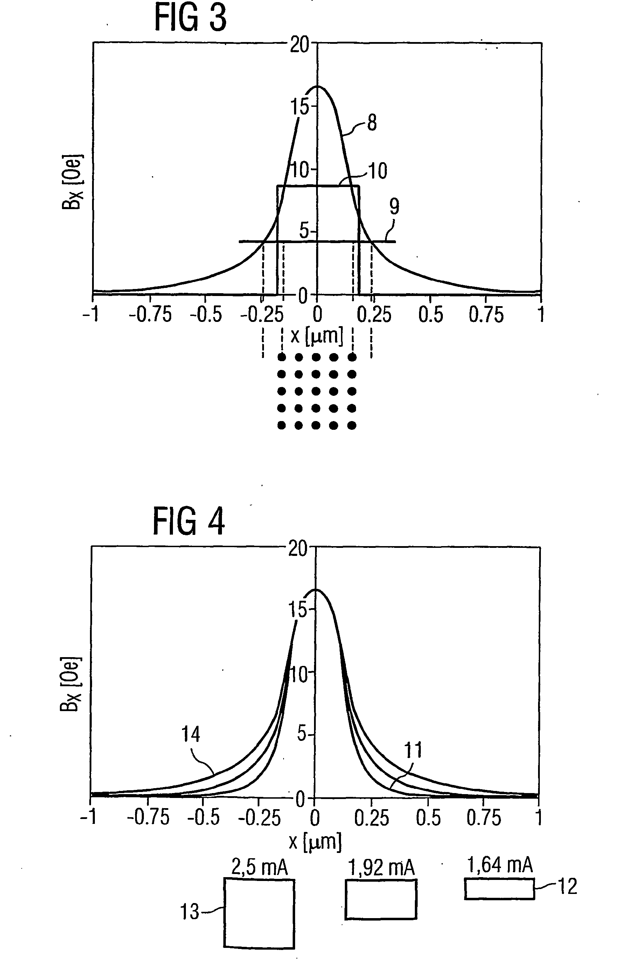

Gemäß dem in Figur 2 gezeigten Koordinatensystem ist die z-Richtung so gewählt, dass der Strom aus der Papierebene heraus senkrecht zum Betrachter verläuft. Die X-Achse kann man sich auf der Oberseite der Zuleitung verlaufend denken. Für den Magnetisierungszustand einer MRAM-Speicherzelle ist nunmehr (aufgrund der Entmagnetisierungsfaktoren) auf der dünnen magnetischen Schicht fast ausschließlich die Magnetfeldkomponente in der Zellenfeld- bzw. Waferebene wichtig, hier also die x-Richtung. Die Gleichungen für die Magnetfeldkomponente Bₓ können nun aufgestellt werden, vergleiche Figur 2, und anschließend auch für einen ausgedehnten (nicht idealisierten) Leiter berechnet werden. (In Figur 3, unten, ist die Aufsplittung eines realen Leiters von quadratischem Querschnitt (ca. 0,25µm x 025µm) in 5x5 "ideale" Leiter angedeutet, wobei rechnerisch über alle einzelnen Magnetfeldkomponenten Bₓ zu mitteln ist.)

Figur 3 zeigt am Beispiel einer bekannten, quadratischen Zuleitung mit den Maßen 0,25µm x 0,25µm die zugehörige reale Kurve 8 des Verlaufs der Magnetfeldkomponente Bₓ (Annahmen: I = 2,5 mA; y = 10 nm). Wie erkennbar, besteht außerhalb der betrachteten Zuleitung, z.B. bei x=.+/-0,25µm, also im Zwischenbereich zur benachbarten Zuleitung, noch ein Streufeld 9 von ca. 4 Oe, welches gemäß dem Verlauf der realen Kurve 8 auch mit noch weiter zunehmenden Abstand x nur relativ langsam gegen Null abfällt. Wichtig ist in jedem Fall, dass die Magnetfeldkomponente Bₓ direkt über der Zuleitung einen Wert erreicht, der größer als der Schaltwert ist. Dieser Wert ist beispielsweise aus den Hysteresekurven des Tunnelelementes zu bestimmen. Desweiteren sollte die Magnetfeldkomponente Bₓ neben der Zuleitung, also bereits im Nahbereich um den Kreuzungspunkt, möglichst kleine Werte, deutlich unterhalb der Schaltschwelle aufweisen. Dies führt zu der in Figur 3 skizzierten idealen Kurve 10 der Magnetfeldkomponente Bₓ, die seitlich senkrecht abfällt.

Die Rechnungen zeigen nun, dass dieser möglichst steile Abfall der Magnetfeldkomponente Bₓ für einen vom Querschnitt her quadratischen Leiter nicht optimal erfüllt ist, für einen von der Dicke her abgeflachten Zuleitungsquerschnitt jedoch zunehmend besser erfüllt wird, wie in Figur 4 dargestellt. In Figur 4 ist insbesondere eine Kurve 11 entsprechend einer extrem flachen Zuleitung 12 gezeigt, der Leiterquerschnitt hat sich deutlich (das Rechteck des Querschnitts ist mindestens dreimal so breit wie hoch) verringert. Es werden jedoch verglichen mit einem quadratischen Querschnitt 13, vgl. die zugehörige Kurve 14, größere Feldkomponenten in x- Richtung generiert, so dass, wie in Figur 4 angedeutet, niedrigere Schaltströme verwendet werden können. Die generierten Flanken der Kurve 11 und der mittleren, mit dem gezeigten mittleren Querschnitt korrespondierenden Kurve, verlaufen wesentlich steiler als beim bekannten quadratförmigen Querschnitt (Kurve 14), so dass bessere Selektivität und gleichzeitig geringere Schaltströme erzielt werden.

Alle Betrachtungen bezüglich der Magnetfeldkomponente Bₓ gelten zunächst für eine einzelne Zuleitung 3 oder 4, können aber ohne weiteres auf die Vektoraddition der beiden Magnetfelder ausgedehnt werden, gegebenenfalls auch auf Konstellationen mit mehr als zwei Schreibleitungen.

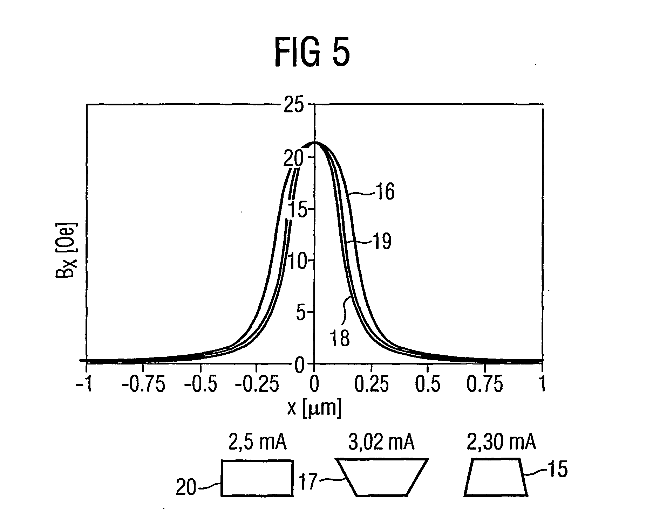

Figur 5 zeigt die Ergebnisse der Rechnungen der Kurven für flache und zusätzlich angeschrägte bzw. für trapezförmige Zuleitungsquerschnitte. Das Ergebnis für den trapezförmigen Querschnitt 15 (Kurve 16) zeigt die Verbindung von geringerem Schaltstrom zusammen mit einer nur leicht verschlechterten Selektivität. Im Falle des angeschrägten Querschnitts 17 (Kurve 18) ergibt sich eine ganz leicht verbesserte Selektivität zusammen mit einem höheren Schaltstrom. Die in Figur 5 hell dargestellte Kurve 19 entspricht dem Querschnitt 20 dort, bzw. dem mittleren Querschnitt in Figur 4. Der Unterschied in der Amplitude der Kurve 19 gegenüber der mittleren Kurve in Figur 4 ergibt sich aus der höheren Stromstärke von 2,5mA in Figur 5, die als Vergleichsbasis für die weitergehend modifizierten Querschnitte 15 und 17 gewählt sind.

## Patentansprüche

1. Magnetoresistiver Speicher (MRAM)
mit einer Vielzahl von Magnet-Speicherzellen (1, 2), die an den Kreuzungspunkten eines aus einer Matrix von Spalten- und Zeilenzuleitungen (3, 4) aufgebauten Zellenfeldes angeordnet und an diese zum Leiten von Lese- und Schreibströmen vorgesehenen Zuleitungen (3, 4) angeschlossen sind,
wobei sich bei einer Schreiboperation die durch die Schreibströme in den jeweiligen Zuleitungen (3, 4) erzeugten Magnetfelder in einem wahlfreien Kreuzungspunkt addieren und **dadurch** eine Ummagnetisierung der dortigen Speicherzelle(1, 2) ermöglichen, und wobei
die Form der Zuleitungen (3, 4) durch Abweichen von einem quadratischen Querschnitt (13) derselben derart optimiert ist, dass die Zuleitungen (3, 4) einen Querschnitt (12) in Form eines flachen Rechtecks aufweisen, so dass die in der Zellenfeldebene liegende Magnetfeldkomponente Bₓ mit zunehmender Entfernung vom Kreuzungspunkt ausreichend rasch abnimmt, und **dadurch gekennzeichnet, dass** die Zuleitungen (3, 4) einen Querschnitt (15, 17) in Form eines seitlich angeschrägten Rechtecks aufweisen.

2. Magnetoresistiver Speicher MRAM) nach Anspruch 1,
**dadurch gekennzeichnet, dass** das Rechteck mindestens dreimal so breit wie hoch ist.

3. Magnetoresistiver Speicher (MRAM) nach einem der vorangehenden Ansprüche, **dadurch gekennzeichnet, dass** der MRAM auf einem Halbleitersubstrat positioniert ist, in dem eine Schaltung zur Erzeugung der Lese- und Schreibströme integriert ist, und dass die Zuleitungen (3,4) in das Leiterbahnsystem der Schaltung integriert sind.

## Claims

1. Magnetoresistive memory (MRAM)
having a multiplicity of magnetic memory cells (1, 2), which are arranged at the crossover points of a cell array constructed from a matrix of column and row leads (3, 4) and are connected to said leads (3, 4), which are provided for conducting read and write currents,
in which case, in the event of a write operation, the magnetic fields generated by the write currents in the respective leads (3, 4) are added at a random crossover point and thereby enable a magnetization reverse of the memory cell (1, 2) there, and in which case
the form of the leads (3, 4) is optimized by deviation from a square cross section (13) thereof in such a way that the leads (3, 4) have a cross section (12) in the form of a flat rectangle, so that the magnetic field component Bₓ lying in the cell array plane decreases sufficiently rapidly with increasing distance from the crossover point, and **characterized in that** the leads (3, 4) have a cross section (15, 17) in the form of a laterally bevelled rectangle.

2. Magnetoresistive memory (MRAM) according to Claim 1,
**characterized in that** the rectangle has a width at least three times greater than its height.

3. Magnetoresistive memory (MRAM) according to one of the preceding claims, **characterized in that** the MRAM is positioned on a semiconductor substrate in which a circuit for generating the read and write currents is integrated, and **in that** the leads (3, 4) are integrated into the interconnect system of the circuit.

## Revendications

1. Mémoire vive magnétique (MRAM)
comportant une pluralité de cellules de mémoire magnétiques (1, 2) qui sont disposées aux points d'intersection d'un champ de cellules constitué d'une matrice de conducteurs de colonne et de conducteurs de ligne (3, 4) et auxquelles sont raccordés des conducteurs (3, 4) destinés à amener des courants de lecture et des courants d'écriture,
dans laquelle, lors d'une opération d'écriture, les champs magnétiques produits par les courants d'écriture dans les conducteurs concernés (3, 4) s'additionnent à un point d'intersection quelconque et permettent ainsi une inversion magnétique de la cellule de mémoire qui s'y trouve (1, 2), et dans laquelle
la forme des conducteurs (3, 4) est optimisée, en s'écartant d'une section carrée (13) de ces derniers, de telle sorte que les conducteurs (3, 4) présentent une section (12) en forme de rectangle plat de manière que la composante de champ magnétique Bₓ située dans le plan de champ de cellules diminue suffisamment vite au fur et à mesure que l'on s'éloigne du point d'intersection,
et **caractérisée en ce que** les conducteurs (3, 4) présentent une section (15, 17) en forme de rectangle biseauté latéralement.

2. Mémoire vive magnétique (MRAM) selon la revendication 1, **caractérisée en ce que** le rectangle est au moins trois fois plus large que haut.

3. Mémoire vive magnétique (MRAM) selon l'une des revendications précédentes, **caractérisée en ce que** la mémoire vive magnétique est placée sur un substrat semiconducteur dans lequel est intégré un circuit servant à produire les courants de lecture et les courants d'écriture, et **en ce que** les conducteurs (3, 4) sont intégrés dans le système de pistes conductrices du circuit.
